# EUROPEAN PATENT SPECIFICATION

(11) **EP 0 963 602 B1**
(45) Date of publication and mention of the grant of the patent: **03.01.2007**
(21) Application number: 97915867.2
(22) Date of filing: 17.03.1997
(51) Int. Cl.: H01L 21/762, H01L 27/06, H01L 23/66

(54) **MICROWAVE INTEGRATED CIRCUITS AND PROCESS OF MAKING THE SAME**
INTEGRIERTE MIKROWELLENSCHALTUNGEN UND VERFAHREN ZUR HERSTELLUNG DERSELBEN
CIRCUITS INTEGRES HYPERFREQUENCES ET PROCEDE DE LEUR PRODUCTION

(30) Priority: 22.03.1996 US 13982 P; 22.03.1996 US 17120 P
(43) Date of publication of application: 15.12.1999
(73) Proprietor: THE WHITAKER CORPORATION, Wilmington, Delaware 19808 (US)
(72) Inventor: BOLES, Timothy, Edward, Tyngsboro, MA 01879 (US); GOODRICH, Joel, Lee, Westford, MA 01886 (US)
(74) Representative: Warren, Keith Stanley
(86) International application number: PCT/US1997/003468
(87) International publication number: WO 1997/035340

(56) References cited:
- EP-A- 0 342 094
- EP-A- 0 534 271
- EP-A- 0 592 002
- US-A- 5 268 310

## Description

### Field of the Invention

The present invention relates to a microwave integrated circuit having a precise dielectric thickness between the top surface and the bottom surface of the integrated circuit.

### Background of the Invention

Heterolithic microwave integrated circuits (HMIC) are one viable approach to low cost mass produced integrated circuits for rf and microwave applications. To this end, the use of the heterolithic structure in which silicon pedestals are selectively disposed about various materials to include glass for fabrication of integrated circuits, has been employed in a variety of applications. Examples of such integrated circuits and the processes for the manufacture thereof are as found in U.S. Patents 5,268,310 and 5,343,070 to Goodrich et al, the disclosures of which are specifically incorporated herein by reference. In such a integrated circuit, what is generally required is the ability to make series connections and elements on the top surface isolated from connections on the bottom surface. Additionally, the ability to make required connections from the top surface of the integrated circuit to the bottom surface is desired.

The interconnections from devices on the top surface to the bottom surface on which is disposed the ground plane of the HMIC are relatively straight forward. These interconnections are generally effected by the use of heavily doped silicon pedestals for conduction of current from the top surface to the bottom surface of the IC. Conversely, in order to effect the series connections and elements on the top surface, the silicon pedestals effect and are connected to elements on the top surface of the HMIC, but are isolated from the ground plane. In order to achieve this isolation, an insulating material such as polyimide is disposed between the pedestal and the ground plane to act as an isolator between the top surface and the bottom surface so as to electrically isolate selected portions of the top surface from the bottom surface.

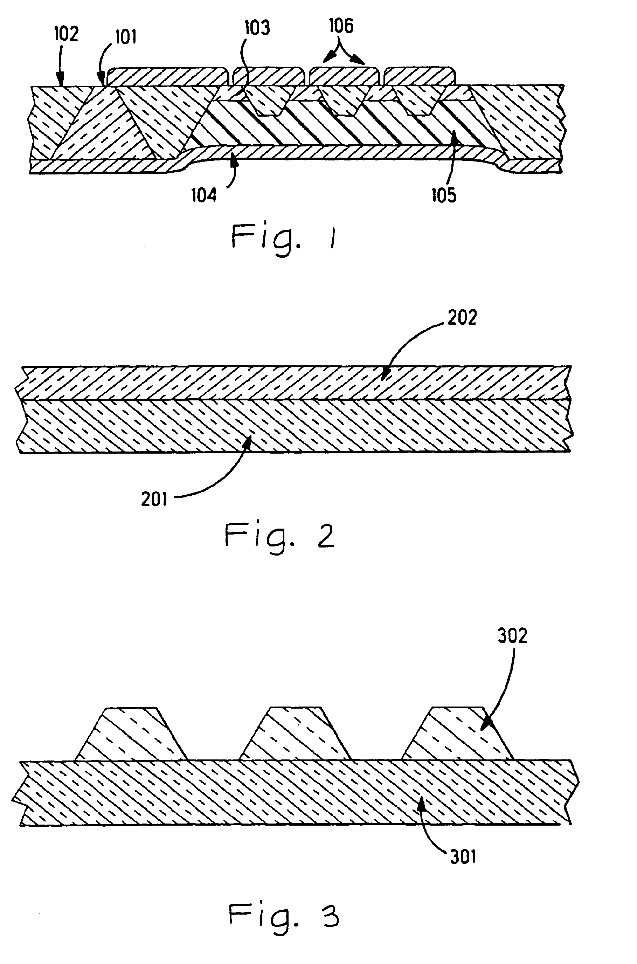

Figure 1 shows the final result of the prior technique of manufacture for the HMIC. The general structure having the silicon pedestals 101 having the glass material 102 for selective isolation of the various pedestals from one another is a relatively standard structure as is described in the above referenced patent application and patent. In the process of fabricating the structure shown in Figure 1, those pedestals 103 which are effectively isolated from the lower surface of the substrate, a metal layer 104, are effected as follows. After the formation of a pedestal such as that shown at 101, the undersurface or backsurface of the wafer is selectively etched in order to backfill the etched portion with an electrically nonconductive material such as polyimide 105. Thereafter, the metal layer 104 is deposited through standard technique and the selected isolation of elements 106 from the metal ground plane 104 in order to effect the desired interconnections on the top surface of the substrate is achieved.

One of the critical factors in the use of the heterolithic structure as is shown in Figure 1 is the overall thickness of the integrated circuit. To this end, the thickness of the glass used as the dielectric dictates the inductance of various elements on the top side of the substrate. The various elements, such as inductors, that are used in the rf circuit on the top surface of the substrate must be properly impedance matched and in fact may be part of the matching circuit. Accordingly, the elements such as inductors, which form resonators in a matching circuit, must have a resonant condition at a prescribed frequency in order to properly effect the impedance matching of the various elements. Because the thickness of the substrate dictates the inductance of various resonant elements, it is clear that the precision of the resonant circuit elements on the top surface of the substrate is dependent upon the precision of the thickness of the substrate. Accordingly, in the processing of heterolithic microwave integrated circuits, the thickness of the dielectric between the top surface circuit element and signal lines and the ground plane of the HMIC must be maintained to a very precise value.

In order to properly effect the desired thickness of the dielectric and the isolation of certain elements as shown in Figure 1, the wafer is processed with the precision of the thickness in mind. To this end, the process of bonding the glass to the silicon through standard fusion techniques as is described in the above referenced patents is effected. Thereafter, the silicon pedestals are etched through the back of the wafer after the final thickness of 5 to 8 mils is achieved. Accordingly, cavities are formed and these cavities must be filled with an electrically nonconductive material in order to properly isolate the selected silicon pedestals from the metal ground plane which is deposited as shown at 104. It is clear that the desired thickness is maintained and thereby the performance characteristics of the various elements and the required impedance matching is carried out with great precision.

Unfortunately, the process fabricating the HMIC with the vias as well as pedestals isolated from the ground plane as is shown in Figure 1 has proved to be very problematic. The problems encountered in processing the wafer generally are direct results of attempts to process wafers which have been etched to be too thin. Often this is manifest in breakage, as well as incomplete electrical isolation of the series elements. The latter is difficult to inspect after fabrication. The resulting yields are unfortunately very unpredictable ranging from 0% to a maximum of in the order of 68%. Even if it were possible to consistently achieve the yields of 68%, this is an unacceptable value if one is to maintain low cost as is required in the rf and microwave wireless markets.

Another conventional microwave integrated circuit is disclosed in US-A-5,102,822. This integrated circuit includes a mesa-type component that is located within a dielectric recess and which is interconnected with planar components by microstrip lines.

A further microwave integrated circuit is known from EP-A-0 592 002. Here, the integrated circuit includes a passive substrate disposed opposite a semiconductor substrate. Elements of the passive substrate are connected to elements of the semiconductor substrate via through-holes.

Accordingly, what is needed is a new microwave integrated circuit which affords the precision of thickness of the dielectric between the top surface and the ground plane, thereby enabling good performance characteristics of the resulting circuit while increasing the manufacture yields to an acceptable and consistent level. To this end, what is needed is integrated circuits having selectively isolated pedestals for series elements and circuits as well as vias for interconnecting the top surface of the HD4IC to the lower surface ground plane with a precise dielectric thickness between the top surface and bottom surface.

### Summary of the Invention

The present invention relates to a microwave integrated circuit in accordance with claim 1 having selectively disposed silicon conduction members and a dielectric material disposed about said silicon conduction members forming the substrate of the integrated circuit. A novel process for fabricating the HMIC in accordance with claim 11 is also disclosed. The dielectric material used in fabricating the dielectric layer between signal lines and elements disposed on the top surface of the HMIC and the ground plane for the integrated circuit on the lower surface of the dielectric is fabricated to have a very precise thickness in order to properly effect the performance and impedance matching of the various elements as described above. Furthermore, the material used as the dielectric is a low loss material at high frequency. The dielectric of the present invention is a single material formed concurrently in the fabrication of the HMIC as opposed to multiple materials which require a backfilling step as is conventionally done.

The present invention envisions two basic structures for various applications in the high frequency art. To this end in one embodiment, the silicon conductive members are fabricated so that they are in electrical contact with elements and devices on the top surface of the substrate of the integrated circuit, while they are electrically insulated from the ground plane by the dielectric material. This particular embodiment in which the silicon conduction members are referred to as pedestals, enables selective isolation of series elements on the top surface from the ground plane on the bottom surface. These elements on the top surface are for example schottky diodes which are required to be in series connection on the top surface. A second embodiment of the present invention envisions an application wherein both isolated pedestals and vias are fabricated in the construction of the HMIC. To this end the pedestals which are isolated from the lower surface ground plane are used as is described in the first embodiment described above. Furthermore, silicon conduction members can be fabricated to effect an electrical connection from the top surface on which the integrated circuit and signals lines are disposed, and the lower surface ground plane. Silicon conduction members used in this manner are referred to as vias.

The integrated circuits as described above, have the performance advantages required and yet are fabricated in consistently high yields as described herein. The result is a heterolithic microwave integrated circuit having a low final cost while maintaining the required performance.

### Objects, Features, and Advantages

It is an object of the present invention to have HMIC devices with selective isolation of series components from the IC ground plane alone or in combination with the selective electrical connections of elements on the top surface of the HMIC to the ground plane.

It is a feature of the present invention to have a glass substrate having the required HMIC structure disposed thereon and the required selectively anisotropically etched silicon conductive members disposed therein.

It is a further feature of the present invention to have a heterolithic microwave integrated circuit having the required system performance characteristics through a precise dielectric thickness.

It is an advantage of the present invention to have the required system performance of resonant circuit elements achieved through effective and proper electrical isolation.

It is a further advantage of the present invention to have a low cost HMIC without sacrificing performance.

It is an object of the present invention to have a process for fabricating heterolithic microwave integrated circuits in large quantity and high consistent yield.

It is a further object of the present invention to have a process for fabricating HMIC devices with selective isolation of series components and selective electrical connections through vias.

It is a feature of the present invention to process a relatively thick glass substrate having the required HMIC structure disposed thereon, including the required selectively anisotropically etched silicon pedestals.

It is a further feature of the present invention to effect a heterolithic microwave integrated circuit having the required system performance characteristics through a precise dielectric thickness.

It is an advantage of the present invention to have the required system performance of resonant circuit elements achieved through effective and proper electrical isolation.

### Brief Description of the Drawings

FIGURE 1 is a cross-sectional view of the prior art showing the polyimide isolation layers deposited to effect the isolation of selected silicon pedestals.
FIGURE 2 to FIGURE 6 show the processing steps of the embodiment of the present invention having isolated pedestals.
FIGURES 7-11 show the processing steps of the embodiment having both vias and isolated pedestals.

### Detailed Description of the Invention

Turning to Figure 2 the glass substrate layer 201 is shown having been properly fused to a silicon wafer 202 through standard technique. The glass substrate is approximately 20 mils in thickness while the silicon wafer is approximately 15 mils in thickness. The fusion of the two layers is as described herein. The preferred material for the glass is for example Corning 7070, although any dielectric material having a low loss at high frequency and is mechanically expansion matched to silicon will work. The silicon wafer is preferably a monocrystalline material having well-defined crystallographic planes which are exploited during the etching process described herein.

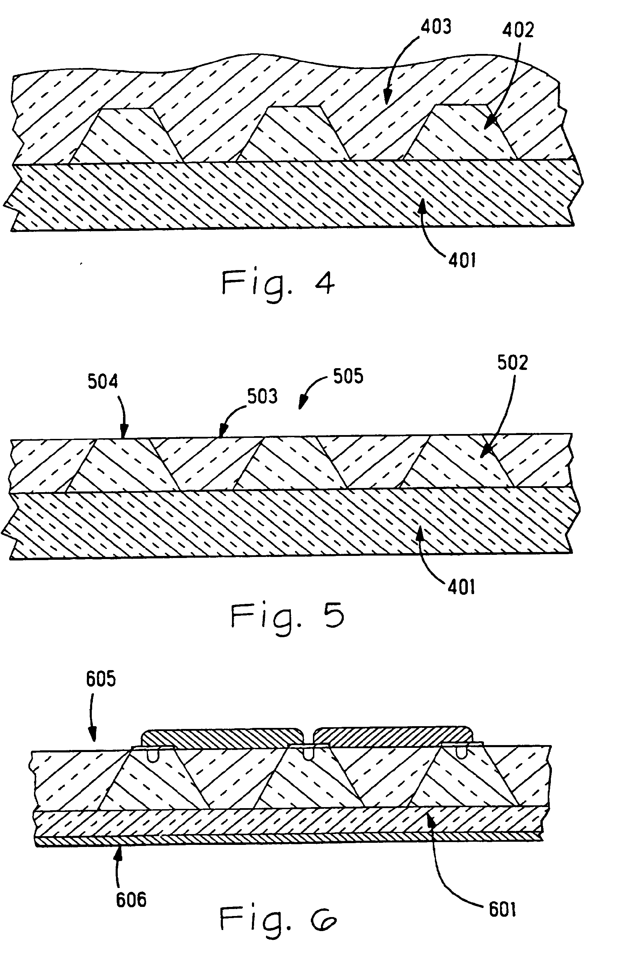

Turning to Figure 3, the first step in the processing by the present invention is shown where the silicon wafer is anisotropically selectively etched to provide silicon pedestals having a height on the order of 3 to 4 mils. This etching of the silicon pedestals is carried out through a wet etch process, for example, as is described in U.S. Patent 4,210,923 to North et al., or the references to Goodrich, et al., the disclosures of which are specifically incorporated herein by reference. The orientation of the silicon pedestal sidewalls and top surfaces are well defined in preferred crystallithographic planes. The pedestals shown in Figure 3 are those supporting electronic circuitry on the top surface. These series elements are to be isolated from the metal ground plane on the lower surface of the glass substrate 201. Finally, it is of interest to note that the silicon wafer in thereof lie the silicon pedestals are doped n⁺ with a suitable donor dopant to a doping concentration to achieve a resistivity on the order of 0.002 - 0.006 ohm/cm. Thereafter, turning to Figure 4 the silicon pedestals 402 are shown effectively isolated from one another electrically through the fusion of a glass material 403 as described above.

The process of fusing glass to silicon in the present invention is as described presently. The silicon having been selectively etched as described above has further a peripheral rim about the wafer that acts as a seal. This seal becomes important in effecting a pressure differential as described herein. The silicon having the selectively etched regions has disposed thereon a glass substrate preferably Corning 7070. This assembly is thereafter disposed in a tube and placed at a selected temperature between the range of about room temperature and about 500°C and is placed in a vacuum chamber. This vacuum chamber is thereafter pumped down to 10⁻⁵ Torr. Thereafter, the assembly is heated to on the order of preferably 800°C. The glass material thereafter becomes malleable and the assembly is thereafter removed from the high pressure environment. In removing the assembly from the vacuum chamber a pressure differential is created. The cavities in the silicon is at approximately 10⁻⁵ Torr and by virtue of the seal effected by the ridge about the periphery of the wafer, this pressure is maintained. However, the assembly, in particular the upper surface of the glass is now at atmospheric pressure on the order of 10³ Torr. This pressure differential enables the malleable glass to be fused into the cavities which are at a very low pressure. During this process, selected small pockets or voids are observed in the lower corners of the pedestals. These pockets are of little concern, since the polishing subsequent to this processing technique effectively eliminates the pockets. Finally, it is of interest to note that the fusion of the glass layer 201 to the silicon substrate 202 does not require the ridge for sealing purposes and can be effected by heating and pressure differential techniques described above.

Thereafter in order to properly planarize the top surface of the substrate to a height approximately level with the top surface of the silicon pedestals as shown in Figure 5, a polishing technique is employed. The polishing technique is a standard technique well known to the artisan of ordinary skill. The polishing height is effected generally to a level so as to expose the pedestals as is shown at 503.

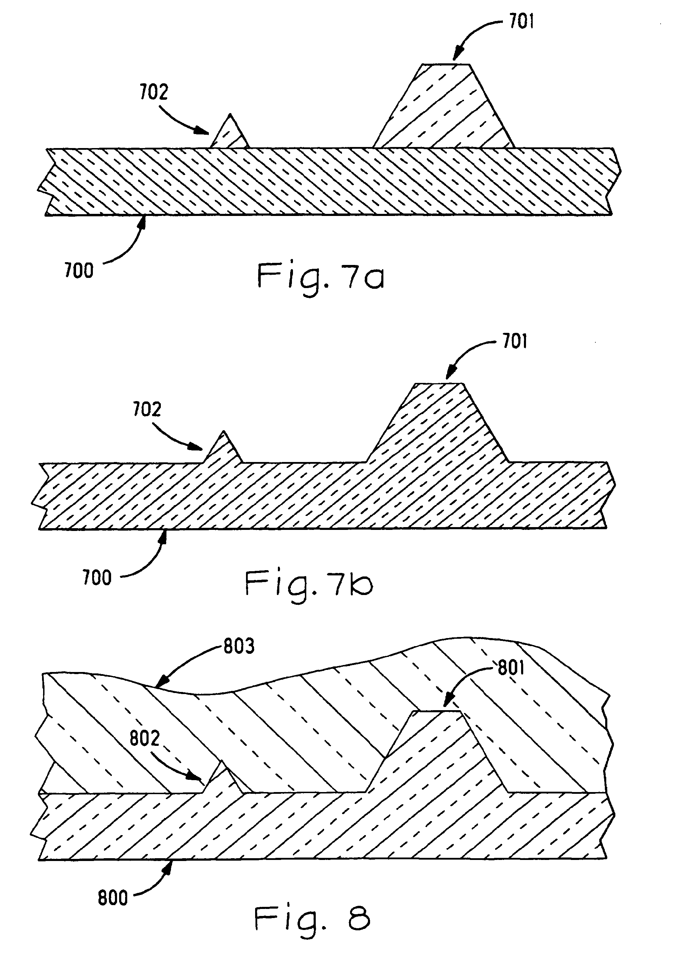

The end result, as shown in Figure 5, is a substrate of glass on the order of approximately 20 mils having the selectively anisotropically etched silicon pedestals 502 selectively isolated from one another by the glass material 503, while being properly exposed as at 504 for effective placement and interconnection of device circuitry on the top surface 505 of the HMIC. In a step not shown through drawing figures, an epitaxial layer is formed as is required on the top surfaces 504 of the silicon pedestals. This processing step is effected for all silicon pedestals as is required in order to properly effect the electrical connections for various devices. To this end the silicon pedestals 302, 402, 502 are as stated highly doped n⁺, and in order to effect devices such as a schottky diode where a metal/semiconductor barrier potentials is required, an epitaxial layer must be grown on the silicon pedestals having a doping concentration which is lower than that of the pedestals in order to avoid the shorting effects that can result through the highly conductive path of the silicon pedestals. Finally, as is shown in Figure 6, the backside surface of glass 601 is polished through the same technique that is used to polish the top surface of the glass described above, in order to effect the proper thickness of the glass layer between the top surface and the ground plane. The thickness of the glass dielectric between the top surface 605 of the HMIC and the ground plane 606 of 5 to 8 mils and has the attendant benefit of performance at the desired center frequencies for resonant elements on the top surface of the substrate.

The second process for manufacture of the present invention is now described. Turning to Figure 7a, a wafer of silicon of a thickness on the order of 35 mils has both selectively located anisotropically etched pedestals 702 and vias 701. After further processing described herein, the pedestals 702 will be electrically isolated from the ground plane and the vias 701 will serve as an electrical path between the top surface and ground plane. Alternatively, a silicon wafer of approximately 15 mils thickness is bonded to a glass substrate 700 through standard technique as described previously. The differing heights and profiles of the pedestals of silicon 701, 702 as shown in Figure 7 are effected through wet etching techniques as described in the reference North et al. To this end, in order to fabricate the pedestals 701 which function as vias in the final product, a differing mask pattern than that of the pedestals 702 which serve to isolate series elements on the top surface of the HMIC is used. Additionally, the profiles and heights of the two different pedestals 701 and 702 are achieved through the different masks and anisotropic etching processes. These etching processes are well known in the art. Finally, to effect different profiles and heights the silicon pedestals are properly doped n⁺ as described above.

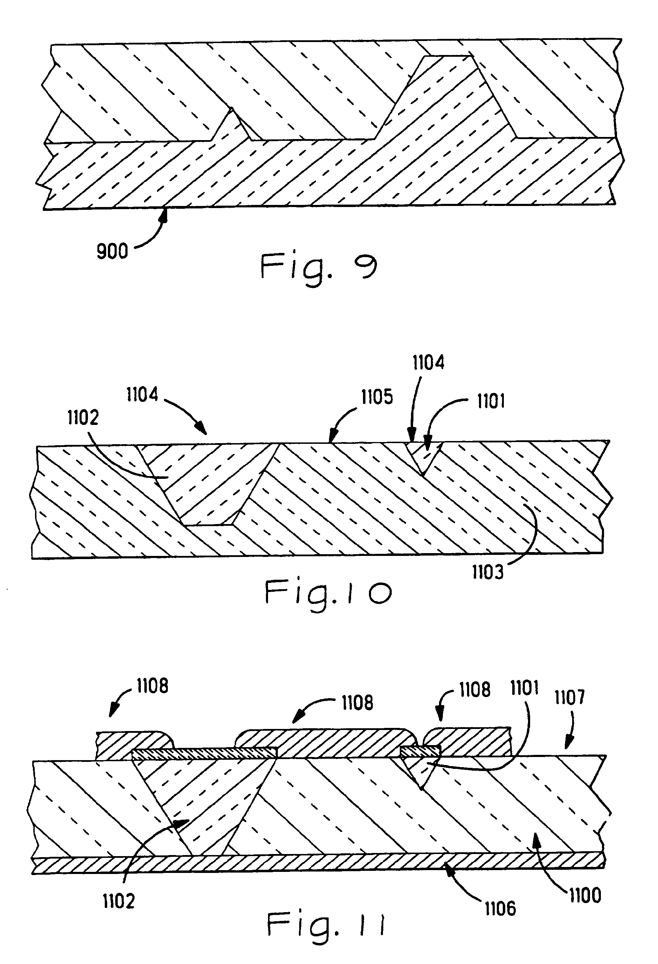

Turning to Figure 8, glass material 803 preferably the same materials as is described above is fused in a thickness on the order of 20 mils on top of the base substrate of silicon 800. This layer of glass effectively isolates the pedestals 802 and 801 and will serve not only in this function but as the dielectric material for the circuit. Turning to Figure 9, we see the final result after replanarization through standard polishing techniques. The glass layer is polished to a thickness on the order of 15 mils, although other thicknesses are possible, and it is preferred to make this layer as thick as possible. Thereafter, the wafer is "flipped over" and the approximately 20 mil thick layer of silicon 900 is removed through standard polishing techniques. This polishing effects a front side surface quality to the backside surface of the wafer. Finally, as is seen in Figure 10 the wafer is a "flipped over" HMIC having selectively disposed glass material in-between the silicon pedestals as desired. The result, as is shown in Figure 10, is a layer of glass on the order of approximately 20 mils in thickness having selectively etched silicon pedestals 1101 and vias 1102 isolated electrically from one another by the glass material 1103. The final step in the processing of the substrate is as shown in Figures 10 and 11 in which the glass layer 1103 is polished to a final thickness on the order of 5 to 8 mils exposing the shunt via 1102 at the lower surface of the substrate. The via 1102 is electrically connected to the ground plane 1106 fabricated by standard metallization techniques. The series elements disposed on the top surface 1105 which are connected to pedestals 1101 having been isolated by the glass material 1103. The polishing process exposes the pedestals and vias as at 1104 enabling effective placement and interconnection of device circuitry on the top surface 1105 of the HMIC.

Thereafter, an epitaxial layer 1107 is formed as is required on the top surface of the silicon pedestals 1104 to effect the barriers as described above. The fabrication of the integrated circuits on the top surface and the various elements, such as devices both active and passive as well as signal lines by standard metallization technique.

As can be appreciated, the resulting structure has functional characteristics of performance that are highly desired while the yield of manufacture is maintained at an acceptable and consistent level. The end result is a low cost heterolithic microwave integrated circuit with the performance characteristics desired. The major reason for the ability to fabricate the HMIC in high yield, therefore at low cost is because the thickness of the glass substrate is always great enough to avoid the attendant problems of processing a thin wafer. The backside processing as described by "flipping" the chip over during the processing enables standard fabrication techniques to be performed on a wafer of adequate thickness to avoid breakage. Furthermore, the layers are of sufficient thickness to act as "handles" during processing. Furthermore, the selective etching of the silicon pedestals enables strict control of the height and profiles of the pedestals for desired function. To this end, both shunt vias as well as electrical isolation of series elements on the top surface from the lower ground plane are enabled through the above described process.

Finally, one of the major drawbacks to silicon vias used in high frequency applications is access losses which can be effected from the top surface circuitry by way of the vias to the lower ground plane. A loss occurs when metal signal lines on the top surface of an HMIC effect losses through the pedestal as follows. The transmission lines on the top surface are deposited on a dielectric, for example glass. The side surfaces of the vias pedestals are made very conductive through superdoping n⁺⁺. This n⁺⁺ layer on the side surfaces of the pedestal is effectively a ground plane in-between the metal layer and the dielectric. It also serves to complete a capacitor. Unfortunately, the material on the side surfaces of the pedestal, the n⁺⁺ layer, is lossy at high frequencies. Accordingly, one technique to reduce the loss is to deposit a layer of cobalt disilicide on the side surfaces of the pedestal. This layer of cobalt disilicide is less lossy than the n⁺⁺ layer. In this way while there is still the coupling to the effective ground plane on the side surfaces of the pedestal via, there is nevertheless a reduction in the loss associated with this coupling. The resulting product of the second process reduces drastically the effective coupling as follows. First of all the geometry of the via is inverted from that which is shown in the conventional design in Figure 1. Thereby, the effective distance between the metal layer on the top surface and the side surface of the pedestal which forms the effective ground plane is great enough so that electromagnetic coupling is drastically reduced. Furthermore, this increase in the distance reduces capacitive coupling greatly. As is well known in the art, capacitive coupling at high frequency transmission is an undesired parasitic effect. Furthermore, a layer of cobalt disilicide is also preferably deposited on the side surfaces of the pedestal in order to effectively reduce the losses by the selected choice of material in addition to the increased distance that the structure of the present invention affords.

The invention having been described in detail, it is clear that there are modifications and variations that are readily conceived by the artisan of ordinary skill. To the extent that these modifications and variations are within the teaching of the present invention, processes for fabricating heterolithic microwave integrated circuits as described above, these modifications and variations are deemed within the scope of the invention. To this end the process for fabricating the HMIC is one that avoids processing a relatively thin wafer, and enables fabrication of the desired HMIC and its attendant performance benefits in high consistent yield through the processing of a relatively thick layer. It is clear that other processing steps could be taken, but to the extent that such processing steps are mere variations in modifications within the purview of the skilled artisan they are deemed within the scope of the present invention.

## Claims

1. A microwave integrated circuit comprising a substrate having a first surface (605, 1105) on which are disposed transmission lines and circuits, a second surface on which is disposed a ground plane (606,1106), at least a first silicon conduction member (502,1101) electrically isolated from said ground plane (606,1106), and a dielectric material (601,1103) disposed between said first surface (505,1105) and said second surface, **characterized in that**:
said dielectric material (601,1103) is disposed about said first silicon conduction member (502,1101) to form said substrate; and
said dielectric material (601,1103) is a single material which extends from the first to the second surface and which electrically isolates the first silicon conduction member (502,1101) from the ground plane (606, 1106)

2. An integrated circuit as recited in claim 1 wherein a precise distance separates said first surface (505,1105) from said second surface.

3. An integrated circuit as recited in any of the preceding claims wherein said dielectric material (601,1103) is of a precise thickness.

4. An integrated circuit as recited in any of the preceding claims wherein said precise thickness is 5 to 8 mils (127µm to 203.2µm).

5. An integrated circuit as recited in any of the preceding claims wherein said single material is a low loss material at radio and microwave frequencies.

6. An integrated circuit as recited in any of the preceding claims further **characterized in that**:
it comprises at least a second silicon conduction member (1102) which electrically connects selected transmission lines or circuits on said first surface (1105) to said ground plane (1106) on said second surface.

7. An integrated circuit as recited in any of the preceding claims further **characterized in that**:
said second silicon conduction members (1102) further comprise electrically conductive members for connecting selected transmission lines and circuits on said first surface (1105) to said ground plane (1106) on said second surface.

8. An integrated circuit as recited in any of the preceding claims wherein said first silicon conduction member (1101) electrically isolated from said ground plane (1106) has fabricated thereon an electronic device.

9. An integrated circuit as recited in any of the preceding claims further **characterized in that**:
said silicon conduction members (1101,1102) are doped to be conductive.

10. An integrated circuit as recited in claim 9 further **characterized in that**:
said first and second silicon conduction members (1101, 1102) electrically connecting said first surface (1105) to said second surface have sidewalls on which is disposed conductive material.

11. A process for fabricating a microwave integrated circuit comprising the steps of fusing a glass substrate (201, 401) to a silicon wafer (202), forming at least one silicon conduction member (502, 504) from said semiconductor wafer (202), fusing a dielectric material (502,503) about said at least one silicon conduction member (502, 504), said dielectric material (403, 503) forming the substrate for the integrated circuit of a desired thickness and polishing said dielectric material (403, 503), and fabricating a conductive ground plane (606, 1106) on a second surface of said substrate whereby:
said polishing of said dielectric material (403, 503) does not reduce said substrate to a thickness less than said desired thickness.

12. A process as recited in claim 11 **characterized in that**:
said silicon conduction members (502,504) are vias (1102) and pedestals (1101), whereby vias (1102) provide an electrical connection between a first surface (1105) of the substrate to the ground plate (1106) and whereby pedestals 1101) are electrically insulated from the ground plate (1106).

13. A process as recited in claim 11 or 12 wherein selected electrical interconnections are fabricated on the first surface (1105) of said substrate.

14. A process as recited in claim 12 or 13 wherein series elements are fabricated on said pedestals (1101).

15. A process as recited in any of claims 11 to 14 further **characterized in that** said silicon conduction members (502,504) are formed by selective anisotropic etching of said semiconductor wafer (202).

16. A process as recited in any of claims 12 to 15 further **characterized in that**:
said silicon vias (1102) are etched to have a height great enough to effect electrical interconnection from said first surface to said second surface.

17. A process as recited in any of claims 12 to 16 further **characterized in that**:
said pedestals (1101) are etched to have a height small enough so as to prevent electrical interconnection between said first surface and said second surface.

18. A process as recited in any of claims 11 to 17 further **characterized in that**:
said silicon conduction members (502,504) are Selectively doped to be conductive.

19. A process as recited in any of claims 11 to 18 further **characterized in that**:
said silicon conduction members (502,504) are doped to have a resistivity in the range 0.002 to 0.006 ohms/cm.

20. A process as recited in any of claims 12 to 19 further **characterized in that**:
said pedestals (1101) are electrically isolated from said second surface by said dielectric material (403,503).

21. A process as recited in any of claims 12 to 20 further **characterized in that**:
said silicon conduction members (502,504) are exposed at said first surface (1105) through said polishing of said dielectric material (403, 503).

## Patentansprüche

1. Integrierte Mikrowellenschaltung die ein Substrat umfasst, das eine erste Fläche (605, 1105), auf der Übertragungsleitungen und Schaltungen angeordnet sind, eine zweite Fläche, auf der eine Masseplatte (606, 1106) angeordnet ist, mindestens ein erstes Silizium-Leitungsbauteil (502, 1101), das elektrisch von der Masseplatte (606, 1106) isoliert ist, und ein dielektrisches Material (601, 1103) aufweist, das zwischen der ersten Fläche (505, 1105) und der zweiten Fläche angeordnet ist, **dadurch gekennzeichnet, dass**
das dielektrische Material (601, 1103) um den ersten Silizium-Leitungsbauteil (502, 1101) angeordnet ist, um das Substrat auszubilden, und
das dielektrische Material (601, 1103) ein einzelnes Material ist, welches sich von der ersten zur zweiten Fläche erstreckt und welches das erste Silizium-Leitungsbauteil (502, 1101) gegenüber der Masseplatte (606, 1106) elektrisch isoliert.

2. Integrierte Schaltung nach Anspruch 1, wobei die erste Fläche (505, 1105) von der zweiten Fläche durch einen genauen Abstand getrennt ist.

3. Integrierte Schaltung nach einem der vorhergehenden Ansprüche, wobei das dielektrische Material (601, 1103) eine genaue Dicke aufweist.

4. Integrierte Schaltung nach einem der vorhergehenden Ansprüche, wobei die genaue Dicke 5 bis 8 mil (127 µm bis 203,2 µm) ist.

5. Integrierte Schaltung nach einem der vorhergehenden Ansprüche, wobei das einzelne Material ein bei Funk- und Mikrowellenfrequenzen verlustarmes Material ist.

6. Integrierte Schaltung nach einem der vorhergehenden Ansprüche, ferner **dadurch gekennzeichnet, dass**
sie mindestens ein zweites Silizium-Leitungsbauteil (1102) aufweist, das ausgewählte Übertragungsleitungen oder Schaltungen auf der ersten Fläche (1105) mit der Masseplatte (1106) auf der zweiten Fläche elektrisch verbindet.

7. Integrierte Schaltung nach einem der vorhergehenden Ansprüche, ferner **dadurch gekennzeichnet, dass**
die zweiten Silizium-Leitungsbauteile (1102) ferner elektrisch leitende Bauteile zum Verbinden ausgewählter Übertragungsleitungen und Schaltungen auf der ersten Fläche (1105) mit der Masseplatte (1106) auf der zweiten Fläche umfassen.

8. Integrierte Schaltung nach einem der vorhergehenden Ansprüche, wobei das erste Silizium-Leitungsbauteil (1101), das von der Masseplatte (1106) elektrisch isoliert ist, darauf ein elektronisches Bauelement hergestellt hat.

9. Integrierte Schaltung nach einem der vorhergehenden Ansprüche, ferner **dadurch gekennzeichnet,**
**dass** die Silizium-Leitungsbauteile (1101, 1102) dotiert sind, um leitfähig zu sein.

10. Integrierte Schaltung nach Anspruch 9, ferner **dadurch gekennzeichnet, dass**
die ersten und zweiten Silizium-Leitungsbauteile (1101, 1102), welche die erste Fläche (1105) elektrisch mit der zweiten Fläche verbinden, Seitenwände aufweisen, auf denen leitfähiges Material angeordnet ist.

11. Verfahren zur Herstellung einer integrierten Mikrowellenschaltung umfassend die Schritte zum Schmelzen eines Glassubstrats (201, 401) an einen Siliziumwafer (202), zum Ausbilden mindestens eines Siliziutn-Leitungsbauteils (502, 504) aus dem Halbleiterwafer (202), zum Schmelzen eines dielektrischen Materials (403, 503) um den mindestens einen Silizium-Leitungsbauteil (502, 504), wobei das dielektrische Material (403, 503) das Substrat für die integrierte Schaltung einer gewünschten Dicke ausbildet, und zum Polieren des dielektrischen Materials (403, 503) sowie zum Herstellen einer leitfähigen Masseplatte (606, 1106) auf einer zweiten Fläche des Substrats, wobei
das Polieren des dielektrischen Materials (403, 503) das Substrat nicht auf eine Dicke kleiner als die gewünschte Dicke reduziert.

12. Verfahren nach Anspruch 11, **dadurch gekennzeichnet, dass**
die Silizium-Leitungsbauteile (502, 504) Durchführungen (1102) und Sockel (1101) sind, wobei die Durchführungen (1102) eine elektrische Verbindung zwischen einer ersten Fläche (1105) des Substrats zur Masseplatte (1106) bereitstellen und wobei die Sockel (1101) von der Masseplatte (1106) elektrisch isoliert sind.

13. Verfahren nach Anspruch 11 oder 12, wobei auf der ersten Fläche (1105) des Substrats ausgewählte elektrische Querverbindungen hergestellt werden.

14. Verfahren nach Anspruch 12 oder 13, wobei auf den Sockeln (1101) Reihenelemente hergestellt werden.

15. Verfahren nach einem der Ansprüche 11 bis 14, ferner **dadurch gekennzeichnet, dass** die Silizium-Leitungsbauteile (502, 504) durch selektives anisotropes Ätzen des Halbleiterwafers (202) erzeugt werden.

16. Verfahren nach einem der Ansprüche 12 bis 15, ferner **dadurch gekennzeichnet, dass**
die Siliziumdurchführungen (1102) geätzt werden, um eine Höhe aufzuweisen, die groß genug ist, um eine elektrische Querverbindung von der ersten Fläche zur zweiten Fläche zu bewirken.

17. Verfahren nach einem der Ansprüche 12 bis 16, ferner **dadurch gekennzeichnet, dass**
die Sockel (1101) geätzt werden, um eine Höhe aufzuweisen, die klein genug ist, um eine elektrische Querverbindung zwischen der ersten Fläche und der zweiten Fläche zu verhindern.

18. Verfahren nach einem der Ansprüche 11 bis 17, ferner **dadurch gekennzeichnet, dass**
die Silikon-Leitungsbauteile (502, 504) selektiv dotiert sind, so dass sie leitfähig sind.

19. Verfahren nach einem der Ansprüche 11 bis 18, ferner **dadurch gekennzeichnet, dass**
die Silizium-Leitungsbauteile (502, 504) dotiert sind, so dass sie einen spezifischen elektrischen Widerstand im Bereich von 0,002 bis 0,006 Ohm/cm aufweisen.

20. Verfahren nach einem der Ansprüche 12 bis 19, ferner **dadurch gekennzeichnet, dass**
die Sockel (1101) durch das dielektrische Material (403, 503) von der zweiten Fläche elektrisch isoliert sind.

21. Verfahren nach einem der Ansprüche 12 bis 20, ferner **dadurch gekennzeichnet, dass**
die Silizium-Leitungsbauteile (502, 504) an der ersten Oberfläche (1105) durch das Polieren des dielektrischen Materials (403, 503) offengelegt sind.

## Revendications

1. Circuit intégré hyperfréquence comprenant un substrat avec une première surface (605, 1105) sur laquelle sont disposés des lignes et des circuits de transmissions, une deuxième surface sur laquelle est disposé un plan de masse (606, 1106), au moins un élément de conduction au silicium (502, 1101) isolé électriquement dudit plan de masse (606, 1106), et un matériau diélectrique disposé entre ladite première surface (505, 1105) et ladite deuxième surface, **caractérisé** de la façon suivante:
ledit matériau diélectrique (601, 1103) est disposé autour dudit élément de conduction au silicium (502, 1101) pour former ledit substrat; et
ledit matériau diélectrique (601, 1103) est un seul matériau qui s'étend de la première à la deuxième surface et qui isole électriquement le premier élément de conduction au silicium (502, 1101) du plan de masse (606, 1106).

2. Circuit intégré selon la revendication 1 dans lequel une distance précise sépare ladite première (505, 1105) de ladite deuxième surface.

3. Circuit intégré selon l'une quelconque des revendications précédentes dans lequel ledit matériau diélectrique (601, 1103) est d'une épaisseur précise.

4. Circuit intégré selon l'une quelconque des revendications précédentes dans lequel ladite épaisseur exacte est entre 5 et 8 mils (127 à 203.2 micromètre).

5. Circuit intégré selon l'une quelconque des revendications précédentes dans lequel ledit matériau seul est un matériau à faible perte aux fréquences radio et hyperfréquence.

6. Circuit intégré selon l'une quelconque des revendications précédentes **caractérisé en** plus par:
il comprend au moins un deuxième élément de conduction au silicium (1102) qui réalise la liaison électrique des lignes et circuits de transmission de ladite première surface audit plan de masse (1106) sur ladite deuxième surface.

7. Circuit intégré selon l'une quelconque des revendications précédentes **caractérisé en** plus par:
lesdits deuxième élément de conduction au silicium (1102) comprennent de plus des éléments de conduction électrique afin de connecter les lignes et circuits de transmission choisies sur ladite première surface (1105) audit plan de masse (1106) sur ladite deuxième surface.

8. Circuit intégré selon l'une quelconque des revendications précédentes où ledit premier élément de conduction au silicium (1101) isolé électriquement dudit plan de masse (1106) a fabriqué sur ce dernier un dispositif électronique.

9. Circuit intégré selon l'une quelconque des revendications précédentes **caractérisé en** plus par:
lesdits éléments de conduction au silicium (1101, 1102) sont dopés pour être conductible.

10. Circuit intégré selon la réclamation 9, **caractérisé en** plus par:
lesdits premier et deuxième éléments de conduction au silicium (1102, 1103) qui réalisent la liaison électrique de ladite première (1105) et ladite deuxième surface ont des surfaces latérales sur lesquelles sont placées des matériaux conductibles.

11. Procédé pour la production d'un circuit intégré hyperfréquence comprenant les étapes de fusion d'un substrat de verre (201, 401) à une plaque de silicium (202), formant au moins un élément de conduction au silicium (502, 504) de ladite plaque de silicium (202), fusionnant un matériau diélectrique (403, 503) autour de l'unique élément de conduction au silicium (502, 504), ledit matériau diélectrique (403, 503) formant le substrat pour le circuit intégré d'un épaisseur voulu et polissant ledit matériau diélectrique (403, 503), et fabricant un plan de masse conductible (606, 1106) sur une deuxième surface dudit substrat où:
ledit polissage dudit matériau diélectrique (403, 503) ne réduit pas ledit substrat à une épaisseur en dessous de ladite épaisseur désirée.

12. Procédé selon la revendication 11 **caractérisé par**:
lesdits éléments de conduction au silicium (502, 504) sont des voies de liaison (1102) et des contacts surélevés (1101), où les voies de liaison (1102) fournissent un contacte électrique entre une première surface (1105) du substrat au plan de masse (1106) et où les contacts surélevés (1101) sont isolés électriquement du plan de masse (1106).

13. Procédé selon les revendications 11 où 12 où des interconnexions électriques choisies sont fabriquées sur la première surface (1105) dudit substrat.

14. Procédé selon les revendications 12 où 13 où les éléments en série sont fabriqués sur lesdits contacts surélevés (1101).

15. Procédé selon l'une quelconque des revendications 11 à 14 **caractérisé** aussi par le fait que lesdits éléments de conduction au silicium (502, 504) sont formés par gravure anisotrope sélective de ladite plaque semi-conducteur (202).

16. Procédé selon l'une quelconque des revendications précédentes 12 à 15 **caractérisé en** plus par:
lesdites voies au silicium (1102) sont gravées pour avoir une hauteur suffisante afin d'effectuer les interconnexions électriques de ladite première surface à ladite deuxième surface.

17. Procédé selon l'une des revendications précédentes 12 à 16 **caractérisé en** plus par:
lesdits contacts surélevés (1101) sont gravés afin d'avoir une hauteur suffisamment petite pour éviter des interconnexions électriques entre lesdites première et deuxième surfaces.

18. Procédé selon l'une des revendications précédentes 11 à 17 **caractérisé en** plus par:
lesdits éléments de conduction au silicium (502, 504) sont dopés de façon sélective afin de les rendre conductibles.

19. Procédé selon l'une des revendications précédentes 11 à 18 **caractérisé en** plus par:
lesdits éléments de conduction au silicium (502, 504) sont dopés afin d'avoir une résistivité entre 0.002 à 0.006 ohms/cm.

20. Procédé selon l'une des revendications précédentes 12 à 19 **caractérisé en** plus par:
lesdits contacts surélevés (1101) sont isolés électriquement de ladite deuxième surface par ledit matériau diélectrique (403, 503).

21. Procédé selon l'une des revendications précédentes 12 à 20 **caractérisé en** plus par:
lesdits éléments de conduction au silicium (502, 504) sont exposés sur ladite première surface (1105) à travers ledit polissage dudit matériau diélectrique (403, 503).
